# EUROPÄISCHE PATENTSCHRIFT

(11) **EP 0 882 294 B1**
(45) Veröffentlichungstag und Bekanntmachung des Hinweises auf die Patenterteilung: **08.03.2000**
(21) Anmeldenummer: 96945894.2
(22) Anmeldetag: 21.11.1996
(51) Int. Cl.: G11C 16/04

(54) **FESTSPEICHER UND VERFAHREN ZUR ANSTEUERUNG DESSELBEN**
READ-ONLY MEMORY AND METHOD OF COMMANDING SAME
MEMOIRE ROM ET PROCEDE DE COMMANDE CORRESPONDANT

(30) Priorität: 06.12.1995 DE 19545557
(43) Veröffentlichungstag der Anmeldung: 09.12.1998
(73) Patentinhaber: SIEMENS AKTIENGESELLSCHAFT, 80333 München (DE)
(72) Erfinder: SEDLAK, Holger, D-81541 München (DE)
(86) Internationale Anmeldenummer: DE9602241
(87) Internationale Veröffentlichungsnummer: WO9721225

(56) Entgegenhaltungen:
- EP-A- 0 509 184
- EP-A- 0 561 271
- EP-A- 0 637 035
- US-A- 5 249 158
- US-A- 5 267 196

## Beschreibung

Die vorliegende Erfindung betrifft einen Festspeicher gemäß dem Oberbegriff des Patentanspruchs 1 sowie ein Verfahren zur Ansteuerung desselben gemäß dem Oberbegriff des Patentanspruchs 17.

Festspeicher (ROM, PROM, EPROM, EEPROM und dergleichen) und Verfahren zur Ansteuerung derselben sind seit langem bekannt.

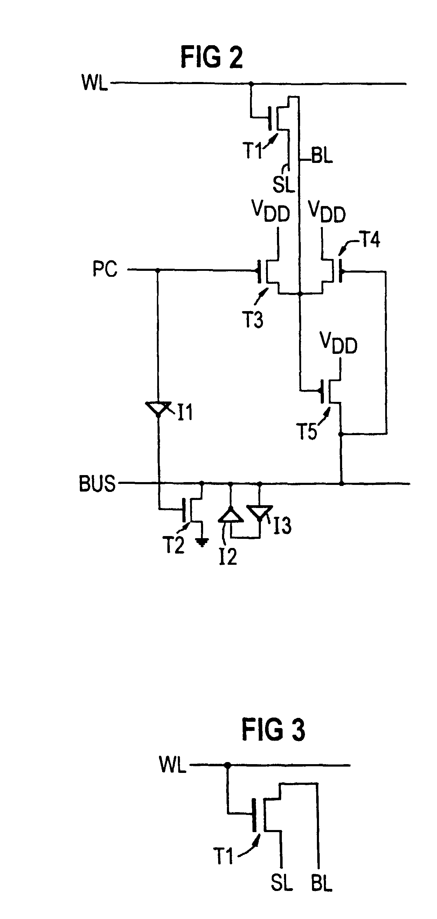

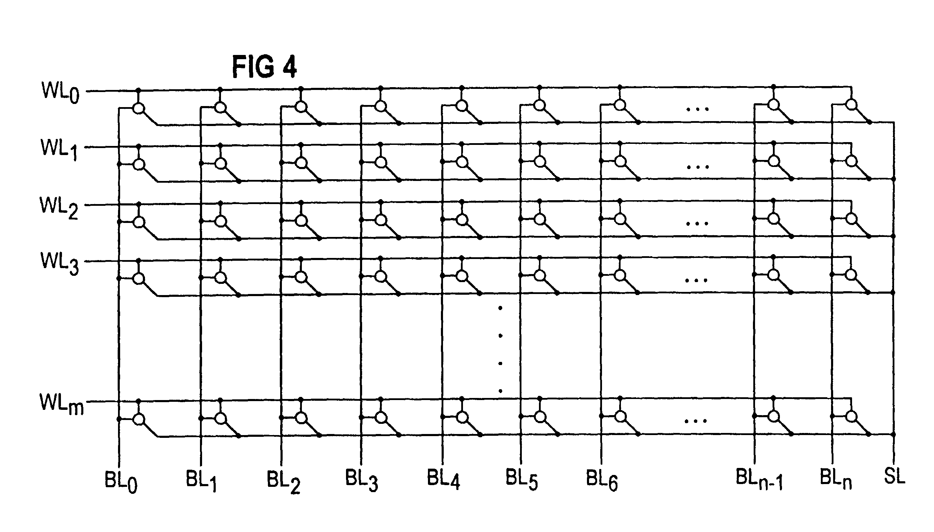

Ein praktisches Beispiel des Aufbaus und der Ansteuerung eines herkömmlichen Festspeichers werden nachfolgend unter Bezugnahme auf die Figuren 3 und 4 anhand eines ROMs erläutert.

Das beschriebene ROM weist eine Vielzahl von Speicherzellen auf, deren Inhalt unter entsprechender Ansteuerung durch Wort-, Bit- und Sourceleitungen auslesbar ist. Beim ROM handelt es sich im Gegensatz zu einigen anderen Arten von Festspeichern (beispielsweise EPROM und EEPROM) um Speicherzellen, deren Aufbau von der beim Auslesen bereitzustellenden Information ("0" oder "1") abhängt. Im einen Fall handelt es sich um einen Transistor, und im anderen Fall ist der Transistor ersatzlos gestrichen, und die sonst mit dem Transistor verbundenen Signalleitungen (Wort-, Bit- und Sourceleitungen) gehen ins Leere.

Die einen Transistor aufweisende ROM-Speicherzelle ist schematisch in Figur 3 gezeigt.

Sie weist, wie bereits erwähnt, einen Transistor, hier in Form eines Feldeffekttransistors T1 auf, dessen Sourceabschnitt mit einer Sourceleitung SL, dessen Drainabschnitt mit einer Bitleitung BL, und dessen Gateabschnitt mit einer Wortleitung WL verbunden ist.

Das Auslesen von "gespeicherten" Daten aus dem ROM funktioniert wie folgt:

Zunächst wird die Bitleitung mittels eines Vorlade- bzw. Prechargesignals auf ein bestimmtes Potential, beispielsweise auf ca. +4 V aufgeladen. Die Bitleitung und deren äußere Beschaltung sind so ausgelegt, daß diese, sofern der Transistor gesperrt ist oder kein Transistor vorhanden ist, das Potential auch nach einer Unterbrechung der Verbindung zur Vorladesignalquelle beibehält.

Wird der Transistor in diesem Zustand zum Lesen angesprochen bzw. selektiert, d.h. wird über die Wortleitung eine Spannung von beispielsweise +5 V an den Gateabschnitt des Transistors gelegt und ist die Sourceleitung mit Masse verbunden, so wird der Speichertransistor leitend, und die auf der Bitleitung vermehrt vorhandenen Ladungsträger fließen über den Transistor auf Masse ab. Das Potential der Bitleitung sinkt dadurch auf 0 V.

Andererseits kann bei einer keinen Transistor aufweisenden Speicherzelle mangels Vorhandenseins des Transistors das durch die Vorladung auf die Bitleitung aufgebrachte Potential nicht abfließen, sondern bleibt im wesentlichen erhalten.

Die vom Speicherinhalt der jeweiligen Speicherzelle abhängenden Potentiale der Bitleitung ermöglichen mithin, den Speicherinhalt zu bestimmen.

Wenngleich andere Arten von Festspeichern einen teilweise völlig andersartigen Aufbau der Speicherzellen aufweisen, weisen sie mit den ROM-Speicherzellen insofern Gemeinsamkeiten auf, als sie an die selben Signalleitungen (Wortleitung, Bitleitung, Sourceleitung) angeschlossen sind und die Signalleitungen zum Lesen mit im wesentlichen den selben Signalen beaufschlagt werden und eine Veränderung der Signale vergleichbare Auswirkungen hat.

Die Wortleitung kann wie beim EEPROM aus mehreren Signalleitungen (Auswahlleitung, Steuerleitung) bestehen, doch hierdurch ergibt sich keine grundlegende Veränderung des beschriebenen allgemeinen Ansteuerungsprinzips.

Die in der Figur 3 gezeigte Speicherzelle ist wie auch die Speicherzellen anderer Arten von Festspeichern bei Vorsehen einer entsprechenden Anzahl derselben zu einem Speicherzellenfeld zusammensetzbar.

Der Aufbau eines derartigen Speicherzellenfeldes ist in Figur 4 dargestellt.

Figur 4 ist eine schematische Darstellung eines Speicherzellenfeldes eines herkömmlichen Festspeichers.

Das gezeigte Speicherzellenfeld weist eine Vielzahl von jeweils mit einem "O" gekennzeichneten einzelnen Speicherzellen gemäß Figur 3 auf, die in mehreren (m) Reihen und mehreren (n) Spalten angeordnet sind.

Die n Elemente einer jeden Speicherzellenfeldreihe sind jeweils mit einer gemeinsamen Wortleitung WL₀, WL₁ ... WLₘ (gegebenenfalls bestehend aus einer Auswahlleitung und einer Steuerleitung) verbunden. Die m Elemente einer jeden Speicherzellenfeldspalte sind jeweils mit einer gemeinsamen Bitleitung BL₀, BL₁ ... BLₙ verbunden. Die Sourceleitungen SL aller Speicherzellen des Speicherzellenfeldes sind zu einer gemeinsamen Sourceleitung zusammengefaßt.

Die Verschaltung der Speicherzellen zu dem in der Figur 4 gezeigten matrixartig aufgebauten Speicherzellenfeld ermöglicht es, den Inhalt der Speicherzellen durch entsprechende Ansteuerung der Wort-, Bit- und Sourceleitungen unter relativ geringem Steueraufwand einzeln aus dem Festspeicher auszugeben.

Gleichwohl ist jedoch der Stromverbrauch beim Lesen relativ hoch und dauert das Lesen relativ lange.

Aus diesem und anderen Gründen kann vorgesehen werden, den Festspeicher so auszubilden, daß die über eine einzelne Wortleitung ansprechbaren Speicherzellen in eine Vielzahl von Gruppen aufgeteilt sind, von denen jeder eine separate gemeinsame Sourceleitung zugeordnet ist.

Diese Maßnahme ermöglicht es, nur diejenigen Speicherzellen zum Auslesen anzusprechen, deren Inhalt auch aus dem Festspeicher ausgegeben werden soll. Genauer gesagt sind beim Auslesen von Daten aus Speicherzellen gegebenenfalls stattfindende Entladevorgänge der vorgeladenen Bitleitungen selektiv auf ganz bestimmte Bereiche innerhalb einer Speicherzellenfeldreihe beschränkbar, was beim Vorsehen von nur einer einzigen gemeinsamen Sourceleitung für alle Speicherzellen des Speicherzellenfeldes nicht möglich ist (das Entladen der vorgeladenen Bitleitungen kann in diesem Fall nur in Einheiten von Speicherzellenfeldreihen erfolgen).

Legt man nämlich die Sourceleitung einer tatsächlich auszulesenden, d.h. auch auszugebenden Speicherzellengruppe auf ein zum Lesen geeignetes Potential (beispielsweise 0 V) und die Sourceleitung einer nicht unbedingt auszulesenden, d.h. nicht auszugebenden Speicherzellengruppe auf ein zum Lesen nicht geeignetes Potential (beispielsweise auf eine hohe Spannung von z.B. +5 V), so kann eine Entladung der vorgeladenen Bitleitung(en) ausschließlich innerhalb der auszugebenden Speicherzellengruppen erfolgen, wohingegen innerhalb der (nicht auszulesenden) anderen Gruppen
1) kein Durchschalten eines oder mehrerer pro Speicherzelle gegebenenfalls vorhandenen Transistors oder Transistoren, und
2) kein Entladen der vorgeladenen Bitleitungen erfolgt.

Die Bitleitungen der verschiedenen Speicherzellengruppen sind über Auf schaltvorrichtungen in Form von Multiplexern mit gemeinsamen Datenausgabeleitungen zur Ausgabe der in den Speicherzellen gespeicherten Daten aus dem Festspeicher verbunden; die Multiplexer schalten die in der jeweils auszulesenden Speicherzellengruppe gespeicherten Daten auf die gemeinsamen Datenausgabeleitungen und geben sie über diese aus dem Festspeicher aus.

Solche und ähnliche Festspeicher und deren Betrieb sind aus der EP-A-0637035, der EP-A-0627742 und der US-5267196 bekannt.

Festspeicher, bei denen die über eine einzelne Wortleitung ansprechbaren Speicherzellen in eine Vielzahl von Gruppen aufteilbar sind, von denen jeder eine separate gemeinsame Sourceleitung zugeordnet ist, lassen sich mit einem geringeren Energiebedarf betreiben als es bei Festspeichern ohne diese spezielle Eigenschaft der Fall ist.

Nichtsdestotrotz ist der Energiebedarf derartiger Festspeicher noch immer relativ hoch.

Der vorliegenden Erfindung liegt daher die Aufgabe zugrunde, den Festspeicher gemäß dem Oberbegriff des Patentanspruchs 1 bzw. das Verfahren zur Ansteuerung desselben gemäß dem Oberbegriff des Patentanspruchs 17 derart weiterzubilden, daß das Auslesen von Daten unter verringertem Energieverbrauch und schneller durchführbar ist.

Diese Aufgabe wird erfindungsgemäß durch die im kennzeichnenden Teil des Patentanspruchs 1 bzw. durch die im kennzeichnenden Teil des Patentanspruchs 17 beanspruchten Merkmale gelöst.

Demnach ist vorgesehen, daß die Aufschaltvorrichtungen dazu ausgelegt sind, unter alleiniger Abhängigkeit vom Bitleitungspotential betrieben zu werden (Patentanspruch 1) bzw. daß bei einem so ausgebildeten Festspeicher ein gruppenweises Auslesen der über eine einzelne Wortleitung ansprechbaren Speicherzellen durchgeführt wird (Patentanspruch 17).

Dadurch können die jeweils auszugebenden Daten ohne den üblicherweise vorgesehenen Multiplexer unmittelbar auf die Datenausgabeleitungen gegeben werden; der Multiplexer und die von diesem getroffene Auswahl der auf die Datenausgabeleitungen durchzuschaltenden Daten kann entfallen.

Durch den Verzicht auf den Multiplexer kann das Auslesen von Daten aus dem Festspeicher unter deutlich verringertem Energieverbrauch und erheblich schneller erfolgen.

Darüber hinaus kann der Festspeicher dadurch einfacher und kleiner hergestellt werden.

Vorteilhafte Weiterbildungen der Erfindung sind Gegenstand der Unteransprüche.

Die Erfindung wird nachfolgend anhand eines Ausführungsbeispiels unter Bezugnahme auf die Zeichnungen näher erläutert. Es zeigen:
Figur 1 eine schematische Darstellung eines Ausführungsbeispiels des Aufbaus des Speicherzellenfeldes eines erfindungsgemäß ausgebildeten ROM,
Figur 2 ein Ausführungsbeispiel einer Anordnung zum direkten Aufschalten von aus selektierten Speicherzellen eines ROM gelesenen Daten auf Datenausgabeleitungen eines Ausgabebusses,
Figur 3 eine schematische Darstellung des Aufbaus einer ROM-Speicherzelle, und
Figur 4 eine schematische Darstellung des Aufbaus eines herkömmlichen ROM-Speicherzellenfeldes.

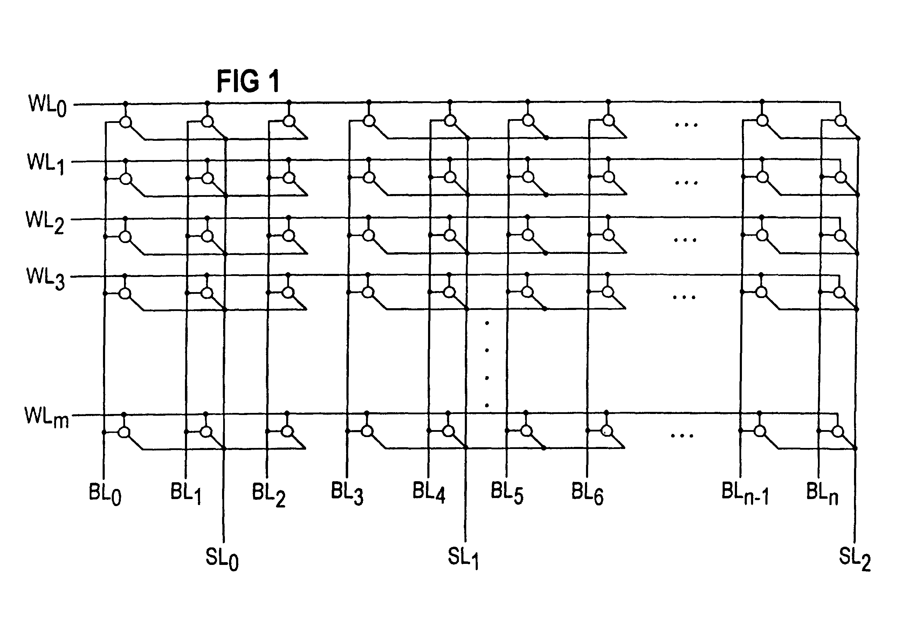

Das in Figur 1 gezeigte Speicherzellenfeld besteht wie das in Figur 4 gezeigte herkömmliche Speicherzellenfeld aus einer Vielzahl von jeweils durch das Symbol "O" gekennzeichneten herkömmlichen Speicherzellen (beispielsweise Speicherzellen der in der Figur 3 gezeigten Art), die in einer Vielzahl (m) von Reihen und einer Vielzahl (n) von Spalten angeordnet sind.

Die n Elemente einer jeden Speicherzellenfeldreihe sind jeweils mit einer gemeinsamen Wortleitung WL₀, WL₁, ... WLₘ (gegebenenfalls bestehend aus einer Auswahlleitung und einer Steuerleitung) verbunden. Die m Elemente einer jeden Speicherzellenfeldspalte sind jeweils mit einer gemeinsamen Bitleitung BL₀, BL₁ ... BLₙ verbunden.

Im Gegensatz zu dem in Figur 4 gezeigten herkömmlichen Speicherzellenfeld sind jedoch die Sourceleitungen SL der Speicherzellen nicht mehr zu einer für alle Speicherzellen des Speicherzellenfeldes gemeinsamen Sourceleitung zusammengefaßt.

Es ist vielmehr eine beliebige Vielzahl von separaten Sourceleitungen SL vorgesehen (in der Figur 1 sind beispielhaft SL₀, SL₁ und SL₂ gezeigt), von denen jede einer bestimmten Gruppe von Speicherzellen innerhalb einer Speicherzellenfeldreihe zugeordnet ist. Anders ausgedrückt sind die Speicherzellen einer Speicherzellenfeldreihe in mehrere Gruppen aufgeteilt, von denen jede eine separate, aber für die Speicherzellen einer jeweiligen Gruppe gemeinsame Sourceleitung aufweist.

In der Regel wird eine Speicherzellengruppe in der Praxis so viele Speicherzellen enthalten wie ein Datenwort (beispielsweise ein Byte) Bits aufweist, und es wird pro Speicherzellenfeldreihe eine Vielzahl derartiger identischer Speicherzellengruppen nebeneinanderliegend (aneinander gereiht) vorgesehen sein.

Allgemein gesprochen kann jedoch jede Speicherzellenfeldreihe je nach Bedarf eine beliebige Vielzahl von Gruppen (mindestens zwei) aufweisen, welche gleich oder unterschiedlich groß sein können, eine beliebige Anzahl von Speicherzellen (mindestens eine) umfassen können, und deren einzelne Elemente bzw. Speicherzellen beliebig über die Speicherzellenfeldreihe verteilt sein können.

Eine der sich daraus ergebenden, vom genannten Regelfall abweichenden Möglichkeiten besteht dann beispielsweise darin, die Speicherzellen jedes x-ten Datenwortes innerhalb einer Speicherzellenfeldreihe zu einer Gruppe zusammenzufassen (um beispielsweise nur Zeichen eines anzuzeigenden Textes, nicht aber die diesen jeweils zugeordneten Anzeigeattribute auslesen zu können).

In der Darstellung der Figur 1 sind drei Speicherzellengruppen eingezeichnet. Die erste (gemäß Figur 1 linke) Gruppe besteht aus drei nebeneinander liegenden Speicherzellen, deren Sourceleitungen zu einer separaten gemeinsamen Sourceleitung SL₀ zusammengefaßt sind. Die sich daran anschließende zweite (gemäß Figur 1 mittlere) Gruppe besteht aus vier nebeneinander liegenden Speicherzellen, deren Sourceleitungen zu einer separaten gemeinsamen Sourceleitung SL₁ zusammengefaßt sind. Die dritte (gemäß Figur 1 rechte) Gruppe besteht aus zwei nebeneinander liegenden Speicherzellen, deren Sourceleitungen zu einer separaten gemeinsamen Sourceleitung SL₂ zusammengefaßt sind.

Die Gruppeneinteilung ist im gezeigten Ausführungsbeispiel für alle Speicherzellenfeldreihen gleich. Die jeweiligen gemeinsamen Sourceleitungen der einander entsprechenden Gruppen in verschiedenen Speicherzellenfeldreihen sind miteinander verbunden. Ein derartiger Aufbau begrenzt zwar den zur Speicherzellenfeldrealisierung erforderlichen Aufwand, ist aber selbstverständlich nicht zwingend. Es kann vielmehr jede Speicherzellenfeldreihe völlig unabhängig von den anderen Reihen beliebig unterteilt werden, und die Sourceleitungen der jeweiligen Gruppen können völlig unabhängig voneinander verlegt und angesteuert werden.

Die beschriebene Gestaltung des Speicherzellenfeldes ermöglicht (unter Verwendung einer entsprechenden Steuervorrichtung) ein gruppenweises Ansprechen (Selektieren) der über eine einzelne Wortleitung adressierbaren Speicherzellen, wobei eine Gruppe, wie vorstehend bereits angedeutet im Extremfall auch nur aus einer einzigen Speicherzelle bestehen kann.

Dies wirkt sich insbesondere beim Auslesen von Daten äußerst vorteilhaft aus, denn bei herkömmlichen Speicherzellenfeldern war, wie eingangs bereits erwähnt, das Auslesen von Daten aus Speicherzellen (im Gegensatz zum Ausgeben von Daten aus dem Festspeicher) nur in (unter Umständen sehr großen) Einheiten von Speicherzellenfeldreihen möglich.

Ein selektives Auslesen aus einer einzelnen Gruppe innerhalb einer Speicherzellenfeldreihe erfolgt weitgehend wie bei herkömmlichen Festspeichern (siehe Figur 3 und darauf bezugnehmende Beschreibung).

Im Unterschied zu herkömmlichen Festspeichern werden (über die entsprechende(n) Sourceleitung(en) jedoch nur diejenigen Sourceanschlüsse mit den zum Lesen erforderlichen Spannung (im vorliegenden Ausführungsbeispiel 0 V) beaufschlagt, die tatsächlich auch ausgegeben bzw. zur Ausgabe benötigt werden. Die nicht auszugebenden bzw. nicht zur Ausgabe benötigten Speicherelemente der betreffenden Speicherzellenfeldreihe werden mit einer zum Lesen, genauer gesagt zum Entladen der vorgeladenen Bitleitung über einen oder mehrere Transistoren nicht geeigneten Sourcespannung (im vorliegenden Beispiel eine hohe Spannung von beispielsweise +5 V) beaufschlagt.

Da einerseits nur die Transistoren der tatsächlich interessierenden Speicherzellen auf Durchgang geschaltet und folglich andererseits auch nur diejenigen Bitleitungen entladen werden, deren Zustand für die Ausgabe von Interesse ist, reduziert sich der Energieverbrauch beim Auslesen von Daten auf ein Bruchteil dessen, was beim Auslesen von Daten aus einem herkömmlichen Festspeicher erforderlich ist.

Die Tatsache, daß die Bitleitungen der nicht interessierenden Speicherzellen beim Lesen der interessierenden Daten nicht entladen werden, kann auch nutzbringend dafür eingesetzt werden, daß die gelesenen Daten der mittels der Sourceleitungen selektierten Speicherzellen (im Gegensatz zu den Daten der jeweils nicht selektierten Speicherzellen) auf Busleitungen legbar sind, über welche die Daten unmittelbar, d.h. ohne Zwischenschaltung des üblicherweise vorgesehenen Multiplexers oder dergleichen aus dem Festspeicher ausgegeben werden können.

Dieser äußerst vorteilhafte Effekt wird nachfolgend anhand der Figur 2 erläutert.

Die Figur 2 veranschaulicht, wie in Abhängigkeit vom Zustand der Bitleitung einer selektierten Speicherzelle ein Signal auf eine Ausgabebusleitung bringbar ist.

Bei den nachfolgenden Erläuterung wird aus Gründen der Anschaulichkeit von den folgenden Voraussetzungen ausgegangen:

Es sei angenommen, daß die n Elemente einer jeden der in Figur 1 gezeigten m Speicherzellenfeldreihen in i gleich große Gruppen aufgeteilt sei, wobei jede Gruppe eine Anzahl von Speicherzellen aufweisen möge, die der Anzahl von Bits der gespeicherten Datenworte entspricht. Die Datenworte seien im vorliegenden Ausführungsbeispiel Bytes, so daß jeden der i Gruppen aus j=8 Speicherzellen besteht.

Von den 8 Speicherzellen der m * i Gruppen ist eine jeweils erste Speicherzelle einer ersten Busleitung, eine jeweils zweite Speicherzelle einer zweiten Busleitung, eine jeweils dritte Speicherzelle einer dritten Busleitung, eine jeweils vierte Speicherzelle einer vierten Busleitung, eine jeweils fünfte Speicherzelle einer fünften Busleitung, eine jeweils sechste Speicherzelle einer sechsten Busleitung, eine jeweils siebte Speicherzelle einer siebten Busleitung, und eine jeweils achte Speicherzelle einer achten Busleitung zugeordnet.

Die Anschaltung einer x-ten Speicherzelle einer beliebigen Gruppe an die x-te Busleitung ist in Figur 2 für ein ROM veranschaulicht; die Verwendung anderer Festspeicher erfordern unter Umständen entsprechend den unterschiedlichen Gegebenheiten geringfügige Modifikationen.

Gemäß Figur 2 weist die Anordnung NMOS-Feldeffekttransistoren T1 und T2, PMOS-Feldeffekttransistoren T3, T4 und T5 und Inverter I1, I2 und I3 auf, die in der gezeigten Weise mit der Wortleitung WL, der Bitleitung BL, der Sourceleitung SL einer Busleitung BUS, einer Vorlade- bzw. Prechargeleitung PC und einer Spannung V_{DD} von beispielsweise ca. 5 V verbunden sind.

Der Transistor T1 ist der in der Figur 3 gezeigte ROM-Speicherzellentransistor.

Zu Beginn eines jeden Lesezyklus wird an die Vorladeleitung kurzzeitig eine niedrige Spannung von beispielsweise 0 V gelegt. Dies bewirkt, daß einerseits die Busleitungen BUS über den dann durchschaltenden Transistor T2 auf Massepotential gezogen werden (der eine Inverter I1 kann hierzu über jeweilge Transistoren T2 mit allen vorhandenen Busleitungen in der gezeigten Weise verbunden sein), und daß andererseits die Bitleitung BL über den dann durchschaltenden Transistor T3 auf das Potential V_{DD} angehoben wird.

Die an die Busleitung BUS angeschlossenen Inverter I2 und I3 bilden ein Halteglied, die das Potential der Busleitung bei Zurückfallen des Transistors T2 in den Sperrzustand auf Massepotential hält (ein derartiges Halteglied ist für jede der Busleitungen vorgesehen). Der Inverter I2 ist dabei jeweils schwach im Verhältnis zum Transistor T5.

Die Bitleitung BL behält ihr Potential bei Zurückfallen des Transistors T3 in den Sperrzustand ebenfalls bei, denn das am Gateanschluß des Transistors T4 anliegende Buspotential (Masse) schaltet über den Transistor T4 die Spannung V_{DD} auf die Bitleitung.

Der beschriebene Vorgang ist für alle Speicherzellen eines Speicherfeldes der selbe.

Es wird nun zunächst das Aufschalten eines gespeicherten Datums von einer selektierten Speicherzelle (die Wortleitung WL liegt auf einer zum Lesen geeigneten Spannung von beispielsweise +5 V, die Sourceleitung SL liegt auf einer ebenfalls zum Lesen geeigneten Spannung von beispielsweise 0 V bzw. auf Masse) auf die Busleitung BUS beschrieben.

Der Transistor T1 entspricht dem in Figur 3 gezeigten herkömmlichen ROM-Speicherzellentransistor.

Bei Beaufschlagung (Selektieren) desselben mit den genannten Signalen über die Wortleitung WL und die Sourceleitung SL wird er leitend und zieht die Bitleitung aktiv auf das Sourceleitungspotential (Masse), da der Transistor T1 stark im Verhältnis zum Transistor T4 ist.

Durch die Potentialänderung der Bitleitung wird der Transistor T5 leitend und schaltet V_{DD} auf den Bus. Durch das Durchschalten des Transistors T5 wird der Transistor T4 sperrend, so daß die Bitleitung BL dann über den Transistor T1 sicher auf Masse liegt.

Im Fall der Selektion einer einen Transistor T1 aufweisenden Speicherzelle wird also die Busleitung BUS auf hohes Potential gelegt, welches durch den Transistor aktiv getrieben ist.

Im Fall der Selektion einer keinen Transistor aufweisenden ROM-Speicherzelle liegt der Zustand vor, wie er nach dem Anlegen des Vorladespannung über die Vorladeleitung PC vorlag, denn ohne Transistor T1 kann die durch den Transistor T4 aktiv auf hohem Potential gehaltene Bitleitung BL nicht entladen werden. D.h., im Fall der Selektion einer keinen Transistor T1 aufweisenden ROM-Speicherzelle bleibt die Busleitung BUS auf Massepotential.

An der Busleitung BUS hängen, wie vorstehend bereits erwähnt, eine Vielzahl weiterer Speicherzellen aus anderen Gruppen (eine Speicherzelle pro anderer Gruppe), die sich jedoch bis auf die eine soeben beschriebene Speicherzelle alle im nicht selektierten Zustand befinden mögen.

Zur Gewährleistung der bestimmungsgemäßen Funktion der in der Figur 2 gezeigten Schaltung dürfen die nicht selektierten Speicherzellen keinen Einfluß auf die Busleitung BUS ausüben, da sie anderenfalls die durch die selektierten Speicherzellen aufgebrachten Daten verändern könnten.

Daß dies bei der in der Figur 2 gezeigten Anordnung trotz deren einfachen Aufbaus tatsächlich jeweils automatisch der Fall ist, wird nachfolgend erläutert.

Eine Speicherzelle ist nicht selektiert, wenn die Sourceleitung hohen Pegel hat und/oder wenn die Wortleitung niedrigen Pegel hat. Eine dieser Bedingungen (teilweise auch beide Bedingungen) sind bei allen Speicherzellen erfüllt, die entweder zwar in der durch die Wortleitung ausgewählten Speicherzellenfeldreihe, aber nicht in der durch die Sourceleitung ausgewählten Gruppe liegen oder in einer nicht ausgewählten Speicherzellenfeldreihe liegen.

Wenn eine einen Transistor T1 aufweisende Speicherzelle mit den bei einer Nicht-Selektion vorliegenden Wortleitungs- und Sourceleitungspotentialen beaufschlagt wird, bleibt der Transistor entweder gesperrt (bei niedrigem Wortleitungspotential) oder die Bitleitung wird über den Transistor mit dem hohen Sourceleitungspotential verbunden.

In beiden Fällen kann die Bitleitung nicht entladen werden, sondern bleibt auf dem anfänglichen (vorgeladenen) hohen Potential, welches den Transistor T5 sperrt und damit eine aktive Beeinflussung der Busleitung ausschließt.

Eine einen Transistor T1 aufweisende Speicherzelle verhält sich im nicht selektierten Zustand also neutral zu der ihr zugeordneten Busleitung.

Gleiches gilt auch für eine keinen Transistor T1 aufweisende Speicherzelle, denn mangels Vorhandenseins des Transistors T1 kann die Bitleitung BL unabhängig vom Selektionszustand der Speicherzelle nicht aktiv entladen werden, so daß auch hier der Transistor T5 gesperrt bleibt und damit eine aktive Beeinflussung der Busleitung ausgeschlossen ist.

Eine keinen Transistor T1 aufweisende Speicherzelle verhält sich im nicht selektierten Zustand also ebenfalls neutral zu der ihr zugeordneten Busleitung.

Obwohl also an jede Busleitung so viele Speicherzellen angeschlossen sind wie Gruppen innerhalb des Speicherzellenfeldes existieren, kann einzig und allein die selektierte Gruppe den gespeicherten Daten entsprechende Signale auf den Bus bringen.

Auf den üblicherweise vorgesehenen Multiplexer, durch den bei jedem Lesezyklus unter den einer vollständigen Speicherzellenfeldreihe entsprechenden gelesenen Daten diejenigen Daten ausgewählt werden mußten, die tatsächlich auch auszugeben sind, kann folglich verzichtet werden.

Zwar ist bei der beschriebenen Anordnung und dem beschriebenen Ansteuerverfahren ein Decoder vorzusehen, der anhand der aus dem Speicher auszulesenden Adresse die zu selektierende Gruppe bestimmt, d.h. die Gruppe bestimmt, deren Sourceleitung im Gegensatz zu allen anderen Sourceleitungen mit einem zum Lesen geeigneten Potential zu beaufschlagen ist, doch sind derartige Decoder äußerst einfach und klein aufzubauen, so daß der dadurch in Kauf zu nehmenden Aufwand völlig vernachlässigbar ist.

Die vorstehende Beschreibung, insbesondere die der Figur 2, bezog sich in erster Linie darauf, daß alle Speicherzellengruppen eines Speicherzellenfeldes gleich groß sind. Dies ist jedoch keine notwendige Bedingung. Die Speicherzellengruppen können vielmehr voneinander verschieden und beliebig groß sein. Die Anzahl der Speicherzellen der größten Speicherzellengruppe sollte dann jedoch der Anzahl der wie beschrieben bereitgestellten Busleitungen entsprechen.

Bemerkenswert und vorteilhaft einsetzbar ist auch der Effekt, daß die Busleitung dann, wenn sie gleichzeitig mit mehreren selektierten Speicherzellen (aus der selben oder verschiedenen Speicherzellengruppen) verbunden ist, gleichzeitig die Funktion eines ODER- oder EXKLUSIV-ODER-Gliedes übernehmen kann.

Der Aufbau des erfindungsgemäßen Festspeichers und das erfindungsgemäße Verfahren zur Ansteuerung desselben wurde vorstehend anhand eines ROM erläutert. Die selben Wirkungen und Vorteile der beschriebenen Maßnahmen lassen sich jedoch auch bei Vorsehen derselben in anderen Arten von Festspeichern (PROM, EPROM, EEPROM etc.) erzielen.

## Patentansprüche

1. Festspeicher mit einer Vielzahl von Speicherzellen, deren Inhalt unter entsprechender Ansteuerung durch Wort-, Bitund Sourceleitungen (WL, BL, SL) auslesbar ist, wobei die über eine einzelne Wortleitung (WL) ansprechbaren Speicherzellen in eine Vielzahl von Gruppen aufgeteilt sind, von denen jeder eine separate gemeinsame Sourceleitung (SL) zugeordnet ist, und wobei die Bitleitungen unterschiedlicher Gruppen von Speicherzellen über Aufschaltvorrichtungen (T5) mit gemeinsamen Datenausgabeleitungen (BUS) zur Ausgabe der in den Speicherzellen gespeicherten Daten aus dem Festspeicher verbunden sind,
**dadurch gekennzeichnet,**
daß die Aufschaltvorrichtungen dazu ausgelegt sind, unter alleiniger Abhängigkeit vom Bitleitungspotential betrieben zu werden.

2. Festspeicher nach Anspruch 1,
**dadurch gekennzeichnet,**
daß die Speicherzellen zumindest teilweise jeweils aus mindestens einem Transistor (T1) bestehen.

3. Festspeicher nach Anspruch 1 oder 2,
**dadurch gekennzeichnet,**
daß die Speicherzellen jeweils mit einer Wortleitung (WL), einer Bitleitung (BL) und einer Sourceleitung (SL) verbunden sind.

4. Festspeicher nach einem der vorhergehenden Ansprüche,
**dadurch gekennzeichnet,**
daß in der selben Reihe des Speicherzellenfeldes vorgesehene Speicherzellen jeweils mit den selben Wortleitungen (WL) verbunden sind.

5. Festspeicher nach einem der vorhergehenden Ansprüche,
**dadurch gekennzeichnet,**
daß in der selben Spalte des Speicherzellenfeldes vorgesehene Speicherzellen jeweils mit der selben Bitleitung (BL) verbunden sind.

6. Festspeicher nach einem der vorhergehenden Ansprüche,
**dadurch gekennzeichnet,**
daß in der selben Spalte des Speicherzellenfeldes vorgesehene Speicherzellen jeweils mit der selben Sourceleitung (SL) verbunden sind.

7. Festspeicher nach einem der vorhergehenden Ansprüche,
**dadurch gekennzeichnet,**
daß eine Speicherzelle zur Speicherung eines Datenbits ausgelegt ist.

8. Festspeicher nach einem der vorhergehenden Ansprüche,
**dadurch gekennzeichnet,**
daß eine Speicherzellengruppe zur Speicherung eines aus mehreren Datenbits bestehenden Datenworts ausgelegt ist.

9. Festspeicher nach Anspruch 8,
**dadurch gekennzeichnet,**
daß das Datenwort ein Datenbyte ist.

10. Festspeicher nach einem der vorhergehenden Ansprüche,
**dadurch gekennzeichnet,**
daß die Speicherzellen einer Speicherzellengruppe beliebig über eine Speicherzellenfeldreihe verteilt sind.

11. Festspeicher nach einem der vorhergehenden Ansprüche,
**dadurch gekennzeichnet,**
daß die Speicherzellengruppen einer Speicherzellenfeldreihe gleich oder unterschiedlich groß sind.

12. Festspeicher nach einem der vorhergehenden Ansprüche,
**dadurch gekennzeichnet,**
daß Datenausgabeleitungen (BUS) vorgesehen sind, von denen jede über eine separate Aufschaltvorrichtung (T5) jeweils mit einer Bitleitung (BL) pro Speicherzellengruppe verbunden ist.

13. Festspeicher nach Anspruch 12,
**dadurch gekennzeichnet,**
daß jede Speicherzelle mit genau einer Datenausgabeleitung (BUS) verbunden ist.

14. Festspeicher nach Anspruch 12 oder 13,
**dadurch gekennzeichnet,**
daß die Datenausgabeleitungen (BUS) in einer Anzahl vorgesehen sind, die der Anzahl der Speicherzellen in der größten Speicherzellengruppe entspricht.

15. Festspeicher nach einem der Ansprüche 12 bis 14,
**dadurch gekennzeichnet,**
daß die Auf schaltvorrichtungen (T5) derart ausgebildet sind, daß von den mit einer Datenausgabeleitung (BUS) verbundenen Speicherzellen nur selektierte Speicherzellen aktiv ein Signal auf die Datenausgabeleitung schalten können.

16. Festspeicher nach Anspruch 15,
**dadurch gekennzeichnet,**
daß die Aufschaltvorrichtungen (T5) jeweils derart ausgebildet sind, daß sie aktiv ein Signal auf die entsprechende Datenausgabeleitung (BUS) schalten, wenn die jeweils zugeordnete Bitleitung ihr Potential in einer vorbestimmten Richtung verändert.

17. Verfahren zur Ansteuerung eines Festspeichers nach einem der Ansprüche 1 bis 16,
**gekennzeichnet durch**
Durchführen eines gruppenweisen Auslesens der über eine einzelne Wortleitung (WL) ansprechbaren Speicherzellen.

18. Verfahren nach Anspruch 17,
**dadurch gekennzeichnet,**
daß nur diejenigen Speicherzellen ausgelesen werden, deren Inhalt anschließend auch aus dem Festspeicher ausgegeben wird.

19. Verfahren nach Anspruch 17 oder 18,
**dadurch gekennzeichnet,**
daß die Daten von nur jeweils einer Speicherzellengruppe ausgelesen werden.

20. Verfahren nach einem der Ansprüche 17 bis 19,
**dadurch gekennzeichnet,**
daß an die Sourceleitung (SL) einer auszulesenden Speicherzellengruppe eine zur Veränderung des Potentials der zugeordneten Bitleitungen geeignete Spannung angelegt wird.

21. Verfahren nach einem der Ansprüche 17 bis 20,
**dadurch gekennzeichnet,**
daß an die Sourceleitungen der nicht auszulesenden Speicherzellengruppen eine das Potential der zugeordneten Bitleitungen nicht verändern könnende Spannung angelegt wird.

## Claims

1. Read-only memory having a multiplicity of memory cells whose contents can be read out with appropriate addressing by word, bit and source lines (WL, BL, SL), the memory cells which can be addressed via an individual word line (WL) being divided into a multiplicity of groups, to each of which a separate common source line (SL) is assigned, and the bit lines of different groups of memory cells being connected via connecting devices (T5) to common data output lines (BUS) for outputting the data stored in the memory cells from the read-only memory, characterized in that the connecting devices are designed to be operated with sole dependence on the bit line potential.

2. Read-only memory according to Claim 1, characterized in that at least some of the memory cells each comprise at least one transistor (T1).

3. Read-only memory according to Claim 1 or 2, characterized in that the memory cells are each connected to a word line (WL), a bit line (BL) and a source line (SL).

4. Read-only memory according to one of the preceding claims, characterized in that memory cells provided in the same row of the memory cell array are each connected to the same word lines (WL).

5. Read-only memory according to one of the preceding claims, characterized in that memory cells provided in the same column of the memory cell array are each connected to the same bit line (BL).

6. Read-only memory according to one of the preceding claims, characterized in that memory cells provided in the same column of the memory cell array are each connected to the same source line (SL).

7. Read-only memory according to one of the preceding claims, characterized in that a memory cell is designed for storing a data bit.

8. Read-only memory according to one of the preceding claims, characterized in that a memory cell group is designed for storing a data word comprising a plurality of data bits.

9. Read-only memory according to Claim 8, characterized in that the data word is a data byte.

10. Read-only memory according to one of the preceding claims, characterized in that the memory cells of a memory cell group are distributed as desired over a row of the memory cell array.

11. Read-only memory according to one of the preceding claims, characterized in that the memory cell groups of a row of the memory cell array are the same size or have different sizes.

12. Read-only memory according to one of the preceding claims, characterized in that data output lines (BUS) are provided, each of which is connected via a separate connecting device (T5) to in each case one bit line (BL) per memory cell group.

13. Read-only memory according to Claim 12, characterized in that each memory cell is connected to precisely one data output line (BUS).

14. Read-only memory according to Claim 12 or 13, characterized in that the data output lines (BUS) are provided in a number which corresponds to the number of memory cells in the largest memory cell group.

15. Read-only memory according to one of Claims 12 to 14, characterized in that the connecting devices (T5) are designed in such a way that only selected memory cells of the memory cells connected to a data output line (BUS) can actively switch a signal to the data output line.

16. Read-only memory according to Claim 15, characterized in that the connecting devices (T5) are each designed in such a way that they actively switch a signal to the corresponding data output line (BUS) when the respectively assigned bit line changes its potential in a predetermined direction.

17. Method for addressing a read-only memory according to one of Claims 1 to 16, characterized by carrying out group-by-group read-out of the memory cells which can be addressed via an individual word line (WL).

18. Method according to Claim 17, characterized in that only those memory cells are read out whose contents are subsequently also output from the read-only memory.

19. Method according to Claim 17 or 18, characterized in that the data from only one memory cell group in each case are read out.

20. Method according to one of Claims 17 to 19, characterized in that a voltage suitable for changing the potential of the assigned bit lines is applied to the source line (SL) of a memory cell group to be read out.

21. Method according to one of Claims 17 to 20, characterized in that a voltage which is unable to change the potential of the assigned bit lines is applied to the source lines of the memory cell groups which are not to be read out.

## Revendications

1. Mémoire ROM comportant une pluralité de cellules de mémoire dont le contenu peut être lu, moyennant une commande correspondante, par des lignes de mot, de bit et de source (WL, BL, SL), les cellules de mémoire adressables par une ligne de mot (WL) individuelle étant divisées en une pluralité de groupes dont chacun se voit attribuer une ligne de source (SL) commune séparée, et les lignes de bit de groupes de cellules de mémoire différents étant reliées par des dispositifs de transmission (T5) à des lignes de sortie de données (BUS) communes, destinées à sortir de la mémoire ROM les données stockées dans les cellules de mémoire, caractérisée en ce que les dispositifs de transmission sont conçus pour être opérés exclusivement en fonction du potentiel des lignes de bit.

2. Mémoire ROM selon la revendication 1, caractérisée en ce que les cellules de mémoire, au moins en partie, sont constituées chacune par au moins un transistor (T1).

3. Mémoire ROM selon l'une des revendications 1 ou 2, caractérisée en ce que les cellules de mémoire sont reliées chacune à une ligne de mot (WL), une ligne de bit (BL) et une ligne de source (SL).

4. Mémoire ROM selon l'une des revendications précédentes, caractérisée en ce que les cellules de mémoire prévues dans la même rangée du champ de cellules de mémoire sont reliées à chaque fois aux mêmes lignes de mot (WL).

5. Mémoire ROM selon l'une des revendications précédentes, caractérisée en ce que les cellules de mémoire prévues dans la même colonne du champ de cellules de mémoire sont reliées à chaque fois à la même ligne de bit (BL).

6. Mémoire ROM selon l'une des revendications précédentes, caractérisée en ce que les cellules de mémoire prévues dans la même colonne du champ de cellules de mémoire sont reliées à chaque fois à la même ligne de source (SL).

7. Mémoire ROM selon l'une des revendications précédentes, caractérisée en ce qu'une cellule de mémoire est conçue pour stocker un bit de données.

8. Mémoire ROM selon l'une des revendications précédentes, caractérisée en ce qu'un groupe de cellules de mémoire est conçu pour stocker un mot de données composé de plusieurs bits de données.

9. Mémoire ROM selon la revendication 8, caractérisée en ce que le mot de données est un byte de données.

10. Mémoire ROM selon l'une des revendications précédentes, caractérisée en ce que les cellules de mémoire d'un groupe de cellules de mémoire sont réparties de façon aléatoire sur une rangée du champ de cellules de mémoire.

11. Mémoire ROM selon l'une des revendications précédentes, caractérisée en ce que les groupes de cellules de mémoire d'une rangée du champ de cellules de mémoire sont de taille identique ou différente.

12. Mémoire ROM selon l'une des revendications précédentes, caractérisée en ce que des lignes de sortie de données (BUS) sont prévues, dont chacune est à chaque fois reliée par un dispositif de transmission (T5) séparé à une ligne de bit (BL) par groupe de cellules de mémoire.

13. Mémoire ROM selon la revendication 12, caractérisée en ce que chaque cellule de mémoire est reliée à précisément une ligne de sortie de données (BUS).

14. Mémoire ROM selon la revendication 12 ou 13, caractérisée en ce que les lignes de sortie de données (BUS) sont prévues en un nombre qui correspond au nombre de cellules de mémoire du plus grand groupe de cellules de mémoire.

15. Mémoire ROM selon l'une des revendications 12 à 14, caractérisée en ce que les dispositifs de transmission (T5) sont réalisés de telle façon que parmi les cellules de mémoire reliées à une ligne de sortie de données (BUS), seules des cellules de mémoire sélectionnées peuvent transmettre activement un signal à la ligne de sortie de données.

16. Mémoire ROM selon la revendication 15, caractérisée en ce que les dispositifs de transmission (T5) sont réalisés de telle façon qu'ils transmettent activement un signal à la ligne de sortie de données (BUS) correspondante, lorsque la ligne de bit attribuée modifie son potentiel dans une direction définie à l'avance.

17. Procédé de commande d'une mémoire ROM selon l'une des revendications 1 à 16, caractérisé par la mise en oeuvre d'une lecture par lots des cellules de mémoire adressables par une ligne de mot (WL) individuelle.

18. Procédé selon la revendication 17, caractérisé en ce que parmi les cellules de mémoire ne sont lues que celles dont le contenu est récupéré par la suite également dans la mémoire ROM.

19. Procédé selon l'une des revendications 17 ou 18, caractérisé en ce que les données de seulement un groupe de cellules de mémoire sont lues à chaque fois.

20. Procédé selon l'une des revendications 17 à 19, caractérisé en ce que la ligne de source (SL) d'un groupe de cellules de mémoire devant être adressé en lecture se voit appliquer une tension capable de modifier le potentiel des lignes de bit attribuées.

21. Procédé selon l'une des revendications 17 à 20, caractérisé en ce que les lignes de source des groupes de cellules de mémoire ne devant pas être adressés en lecture se voient appliquer une tension incapable de modifier le potentiel des lignes de bit attribuées.
